(19) Europäisches Patentamt
European Patent Office
Office européen des brevets

(11) **EP 1 803 969 B1**

(12) **EUROPÄISCHE PATENTSCHRIFT**

(45) Veröffentlichungstag und Bekanntmachung des Hinweises auf die Patenterteilung:
**08.06.2016 Patentblatt 2016/23**

(21) Anmeldenummer: **06023577.7**

(22) Anmeldetag: **13.11.2006**

(51) Int Cl.:
*F16F 15/027* (2006.01)       *G03F 7/20* (2006.01)
*G05D 19/02* (2006.01)       *B23Q 1/38* (2006.01)
*F16F 15/02* (2006.01)

(54) **Schwingungsisolationssystem**

Vibration isolation system

Système d'isolation de vibrations

(84) Benannte Vertragsstaaten:
**CH DE GB LI NL**

(30) Priorität: **30.12.2005 EP 05028718**

(43) Veröffentlichungstag der Anmeldung:
**04.07.2007 Patentblatt 2007/27**

(73) Patentinhaber: **Integrated Dynamics Engineering GmbH**
**65479 Raunheim (DE)**

(72) Erfinder: **Heiland, Peter**
**65479 Raunheim (DE)**

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
**EP-A- 0 502 578          US-A- 4 821 205**
**US-A1- 2001 040 324     US-A1- 2005 041 233**

**Beschreibung**

Gebiet der Erfindung

Die Erfindung bezieht sich auf ein Schwingungsisolationssystem nach dem Oberbegriff des Anspruchs 1 und auf ein Verfahren zur Verkleinerung der Schwingungsisolatoren in einem Schwingungsisolationssystem.

Hintergrund der Erfindung

US 2005/0041233 A1 offenbart ein lithografisches Gerät, mit einem Basisrahmen und einem Bezugsrahmen, die über ein Vibrations-Isolations-Aufhängesystem miteinander verbunden sind. Der Basisrahmen stützt sich über Stützen und piezo-elektronische Aktuatoren an einer Bodenfläche ab. Wenn die Aktuatoren keine Kraft ausüben, ist die Verbindung zu dem Basisrahmen starr. Somit wird kein Schwingungsisolationssystem gegenüber der Bodenfläche gebildet.

Ein gattungsgemäßes Schwingungsisolationssystem ist in US 4 821 205 beschrieben und umfasst ein Lithographiegerät zur Belichtung von Wafern, das sich auf einem schweren Arbeitstisch aus Granit befindet. Das Lithographiegerät ist zusammen mit dem Arbeitstisch mittels mehrerer Schwingungsisolatoren gegen Schwingungen des Untergrundes isoliert. Teil des Lithographiegeräts ist der Objekttisch für den Wafer, bei dem es sich typischerweise um einen Werkstückschlitten handelt, der zusammen mit dem Wafer auf dem "Rest" des Lithographiegeräts verfahrbar, bzw. verschiebbar ist. Dieser "Rest" des Lithographiegeräts wird nicht bewegt und bildet somit ein stationäres Maschinenteil. Wird der Wafer zusammen mit seinem Objekttisch bewegt, so übertragen sich inertiale, d.h. masseninduzierte Kräfte auf das Lithographiegerät und den Arbeitstisch.

EP 502 578 offenbart den Oberbegriff des Anspruchs 1.

Bei allgemeiner Betrachtung eines derartigen Schwingungsisolationssystems befindet sich eine Maschine, ist, auf einer Basismasse. Diese Basismasse wird in der US 4 821 205 von dem Arbeitstisch gebildet. Die Basismasse ist zusammen mit der Maschine schwingungsisoliert gelagert. Die Maschine setzt sich zusammen aus einem stationären und einem beweglichen Teil.

Zur Schwingungsisolation werden als passive Schwingungsdämpfer Federsysteme niedriger Steifigkeit, z.B. Luftlager, eingesetzt. Bei aktiver Schwingungsisolation werden zusätzlich Aktoren eingesetzt, die Sensoren zur Messung des Schwingungszustands sowie einen Regler voraussetzen.

Werden die beweglichen Teile der Maschine bewegt, so treten inertiale Kräfte auf, die sich auf das Gesamtsystem übertragen und auf diese Weise zusätzliche Schwingungen verursachen. Diese Effekte können durch die aktive Schwingungsisolation minimiert werden. Deren Regelungsmechanismus kann auf Inertial-Feedback beruhen. Hierbei misst ein Bewegungssensor die Schwingungen des Systems und gibt die Messergebnisse an den Regler weiter. Aus diesen Messergebnissen berechnet der Regler Signale, die an die Aktoren weitergegeben werden. Diese Aktoren üben Gegenkräfte auf das System aus, die die Schwingungen kompensieren, so dass das Gesamtsystem im Ergebnis schwingungsisoliert ist.

Das Schwingungsisolationssystem umfasst als Masse die Basismasse (bei der US 4 821 205 ist dies der schwere Arbeitstisch), die Maschine (das Lithographiegerät), von der der Objekttisch mit dem Wafer eine bewegliche Masse darstellt. Je größer die Basismasse im Verhältnis zur bewegten Masse ist, desto geringer sind die auftretenden Schwingungen.

Die einzelnen Massen des Systems seien folgendermaßen bezeichnet:

$M_g$: Masse des Gesamtsystems
$M_B$: Basismasse
$M_M$: Gesamtmasse der Maschine
$m_1$: Stationäre Masse der Maschine
$m_2$: Bewegte Masse der Maschine

Zwischen den einzelnen Massen gelten demnach die folgenden Beziehungen:

$$M_g = M_B + M_M \quad \text{und} \quad M_M = m_2 + m_1$$

Die bewegte Masse $m_2$ erzeugt im Falle ihrer Bewegung eine inertiale Kraft der Größe $F_2 = m_2 * a_2$, wobei $a_2$ die Beschleunigung ist, die $m_2$ erfährt. Diese Kraft wirkt auf die Gesamtmasse $M_g$ des Systems und hat den Betrag $F_g = M_g * a_g$. Die Gesamtmasse erfährt also eine Beschleunigung mit dem Betrag $a_g = F_g/M_g$. Die Kräfte $F_2$ und $F_g$ sind dem Betrag nach gleich. Unter Verwendung der obigen Beziehungen für $F_g$, $M_g$ und $M_M$ ergibt sich die Beschleunigung der Gesamtmasse $M_g$ daher zu:

$$a_g = a_2 * \frac{m_2}{M_g} = a_2 * \frac{m_2}{M_B + m_2 + m_1}$$

Da man an möglichst geringen Schwingungen des Gesamtsystems interessiert ist, muss man Sorge tragen, dass die Beschleunigung des Gesamtsystems $a_g$ möglichst gering ist. Da die Masse der Maschine, bestehend aus bewegtem und stationärem Teil, durch die jeweilige Anwendung vorgegeben ist, muss man eine möglichst große Basismasse $M_B$ wählen, damit der Faktor $m_2/(M_B + m_2 + m_1)$ und damit die Beschleunigung $a_g$ möglichst gering wird.

Bei heute eingesetzten Systemen liegt die Masse $m_2$ typischerweise zwischen 20 kg und 50 kg. Die Basismasse $M_B$ liegt zwischen 500 kg und 10.000 kg.

Typischerweise wird bei den bekannten Systemen ein Massenverhältnis von bewegter Masse und Basismasse von 1:20 eingehalten.

Aus den angeführten Beziehungen ergibt sich bei gegebener Maschinenmasse, einschließlich des bewegten Teils, und einem maximal tolerierbaren Wert für die Beschleunigung des Gesamtsystems ohne Berücksichtigung eines Schwingungsisolationssystems die erforderliche Größe der Basismasse automatisch. Nachdem auf diese Weise die Basismasse bestimmt wurde, kann das Isolationssystem ausgelegt werden. Bei Vorgabe einer bestimmten Isolationswirkung sind dann auch die Parameter Eigenfrequenz sowie passive bzw. aktive Dämpfung festgelegt. Zusammen mit der Gesamtmasse des Systems stehen dann alle Parameter des Schwingungsisolationssystem fest.

Nachteilig bei dieser Vorgehensweise ist, dass die Basismasse verhältnismäßig groß gewählt werden muss, um die gewünschten Eigenschaften des Schwingungsisolationssystems zu erhalten. Dies führt zwingend zu der Notwendigkeit des Einsatzes von großen Schwingungsisolatoren.

## Zusammenfassung der Erfindung

Der Erfindung liegt die Aufgabe zugrunde, eine verbesserte Systemkonfiguration bei Schwingungsisolationssystemen zu schaffen.

Diese Aufgabe wird durch ein Schwingungsisolationssystem gemäß Anspruch 1 bzw. durch ein Verfahren zur Verkleinerung der Schwingungsisolatoren gemäß Anspruch 10 gelöst.

Die Erfindung nutzt die Möglichkeit zur Minimierung der auftretenden Effekte dadurch, dass ein zusätzlicher Regelalgorithmus die Bewegungen der Maschine aufnehmen und nahezu gleichzeitig die zum Ausgleich der durch die inertialen Kräfte verursachten Schwingungen notwendigen Gegenkräfte erzeugen kann (Stage-Feedforward).

Im Gegensatz zu den bekannten Schwingungsisolationssystemen berücksichtigt man bei der Auslegung des Systems, dass nicht nur eine Feedback-Regelung einsetzbar ist, sondern auch Feedforwardsysteme zur Dämpfung inertialer Kräfte eingesetzt werden können. Dann muss die Basismasse nicht mehr wie eingangs dargelegt bestimmt werden. Der Grund hierfür liegt darin, dass die maximal tolerierbaren Beschleunigungen nicht lediglich durch die rein passive Maßnahme der Auslegung der Basismasse, sondern vornehmlich durch die Eigenschaften der aktiven Regelung des Feedforward-Systems bestimmt werden.

Mittels derartiger aktiver Regelsysteme können auf einfache Weise Massenverhältnisse zwischen bewegter und Basismasse von nur noch 1:7 - oder weniger - erreicht werden. Es ist sogar vorstellbar, als Basismasse nur noch ein mechanisches Interface zwischen zu lagernder Maschine und den Schwingungsisolatoren einzusetzen.

Auf diese Weise wird die Masse des Gesamtsystems deutlich verringert. Eine derart verringerte Gesamtmasse erlaubt den Einsatz deutlich kleinerer und damit kostengünstigerer Schwingungsisolatoren.

Sind beispielsweise die auftretenden inertialen Kräfte nach Betrag und Zeitpunkt ihres Auftretens vorab bekannt, so können diese Werte gespeichert werden, und im "richtigen Zeitpunkt" in Form von geeigneten Gegenkräften auf das Gesamtsystem gegeben werden, um die Wirkung der von der bewegten Masse verursachten inertialen Kräfte zu kompensieren.

Bei den auftretenden Kräften ist zwischen quasi kontinuierlich auftretenden Kräften und sprungartig auftretenden Kräften zu unterscheiden. Quasi kontinuierlich treten Kräfte auf, wenn beispielsweise ein Maschinenteil über eine gewisse Strecke in eine neue Arbeitsposition verfahren wird. Sprungartige Kräfte treten auf, wenn beispielsweise ein Werkstück auf der Maschine abgelegt oder von der Maschine entfernt wird.

## Kurze Beschreibung der Zeichnungen

Die Erfindung wird anhand der Zeichnungen erläutert.

Dabei zeigt:

Fig. 1 eine schematische Darstellung des prinzipiellen Aufbaus eines herkömmlichen Schwingungsisolationssystems,

Fig. 2 eine schematische Darstellung des prinzipiellen Aufbaus eines erfindungsgemäßen Schwingungsisolationssystems mit verringerter Basismasse,

## Detaillierte Beschreibung

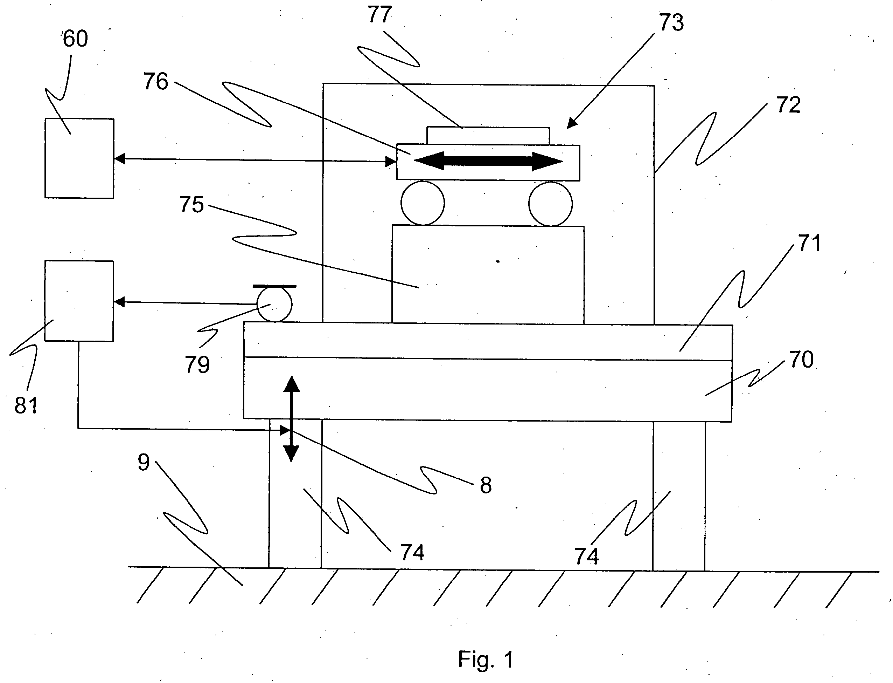

Fig. 1 zeigt schematisch den Aufbau eines herkömmlichen Schwingungsisolationssystems. Eine Maschine 72 ist mit einem Interface 71 auf einem schweren Arbeitstisch 70 der Basismasse $M_B$ gelagert. Das Interface 71 stellt die Struktureinheit zum Halten der Maschine 72 auf dem Arbeitstisch 70 dar und ist Teil der Basismasse $M_B$. Schwingungsisolatoren 74 isolieren das aus schwerem Arbeitstisch 70, Interface 71 und Maschine 72 bestehende Gesamtsystem gegen Schwingungen des Untergrunds 9. Hierbei hat die Maschine die Masse $M_M$.

Die Maschine 72, z.B. ein Lithographiegerät, umfasst einen Werkzeugtisch 75, auf dem sich ein Werkzeugschlitten 76 zusammen mit dem auf ihm befindlichen Werkstück 77 bewegen kann. Werkzeugschlitten 76 und Werkstück 77 bilden das bewegliche Maschinenteil 73 mit der Masse $m_2$ im Sinne der einleitenden Beschreibung. Der Werkzeugtisch 75 ist stationär. Im Falle eines Lithographiegeräts können ferner z.B. die Optik und der Arm, an dem die Optik angebracht ist, zum stationären Maschinenteil gehören. Die Gesamtmasse aller stationären Maschinenteile beträgt $m_1$;

Der Werkzeugschlitten 76 ist mit einem Stage Controller 60 verbunden. Soll der Werkzeugschlitten 76 mit dem darauf befindlichen Werkstück 77 in eine neue Arbeitsposition verfahren werden, so sendet der Stage Controller entsprechende Signale an den Werkzeugschlitten 76. Der Werkzeugschlitten 76 meldet seinen Bewegungszustand an den Stage Controller 60. Diese Rückmeldung an den Stage Controller 60 geschieht mittels Positions-, Geschwindigkeits- und /oder Beschleunigungsdaten.

Am Arbeitstisch 70 oder dem Interface 71 sind Sensormittel 79 angebracht. Diese messen die Bewegungen des Arbeitstisches 70 und melden die Messergebnisse an einen Regler 81 im Feedbackverfahren. Die Sensormittel 79 können als Positions-, Geschwindigkeits- und/oder Beschleunigungssensoren ausgebildet sein.

Zwischen dem Arbeitstisch 70 und den Schwingungsisolatoren 74 befinden sich Aktormittel 8. Diese Aktormittel 8 erlauben es, den Arbeitstisch 70 mit allen darauf befindlichen Maschinenteilen zu bewegen.

In Abhängigkeit von den von den Sensormitteln 79 ermittelten Daten gibt der Regler 81 Steuersignale auf die Aktoren 8 der Schwingungsisolatoren 74, um den Arbeitstisch 70 entgegen seiner Schwingungen anzutreiben und auf diese Weise unerwünschten Bewegungen bzw. Schwingungen des Arbeitstisches 70 und damit des Gesamtsystems entgegenzuwirken.

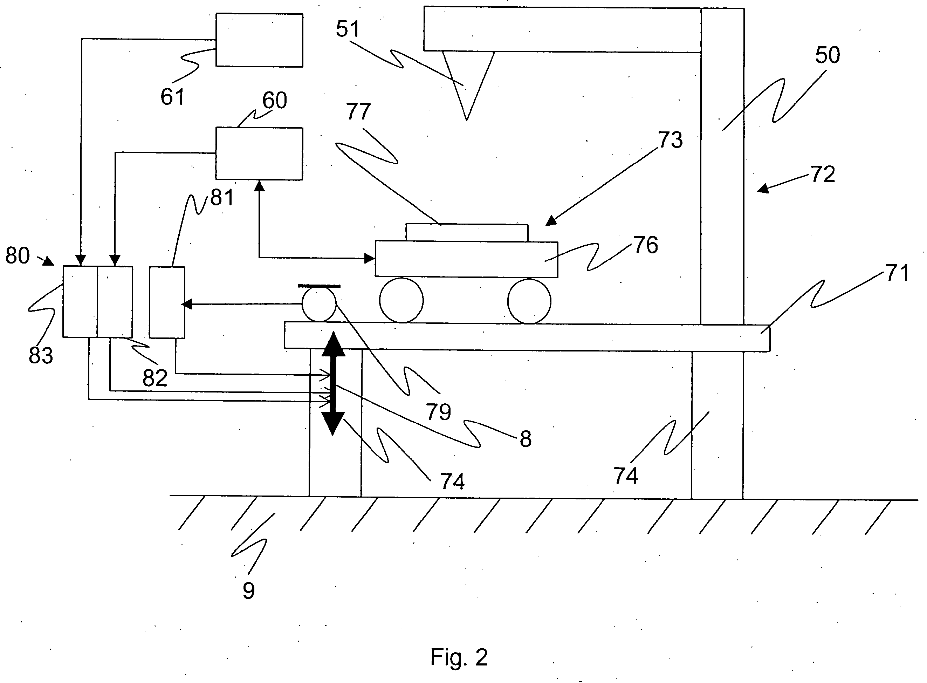

Fig. 2 zeigt eine schematische Darstellung des prinzipiellen Aufbaus eines erfindungsgemäßen Schwingungsisolationssystems mit verringerter Basismasse $M_B$, die durch ein Interface 71 gebildet wird. Das Interface 71 stellt die Verbindungseinrichtung zwischen Maschine 72 und den Schwingungsisolatoren 74 dar und kann im Extremfall beispielsweise lediglich aus Schienen bestehen, auf denen sich der Schlitten 76 bewegt. Im Normalfall gibt es einen Arbeitstisch 70, jedoch verringerter Masse gegenüber dem Stand der Technik. Die Maschine 72 und das Interface 71 zusammen mit dem eventuell vorgesehenen Arbeitstisch 70 sind mittels mehrerer Schwingungsisolatoren 74 auf dem Untergrund 9 schwingungsarm gelagert. Am Interface 71 sind Sensormittel 79 angebracht. Diese messen die Schwingungen des Interfaces 71 und leiten die Messergebnisse an den Regler 81 weiter. Wie im Falle der Fig. 1 betreibt der Regler 81 die Aktormittel 8 um Schwingungen der Schwingungsisolatoren 74 zu dämpfen. Auf dem Interface 71 befindet sich das bewegliche Maschinenteil 73, das den beweglichen Schlitten 76 sowie das darauf befindliche Werkstück 77 umfasst. Die Maschine 72 umfasst noch einen optischen Arm 50 mit integrierter Optik 51 zur Belichtung und/oder Untersuchung des Werkstücks 77.

Neben dem Regler 81 umfasst die Gesamtsteuerungseinrichtung eine Feedforwardeinrichtung 80 für den Ausgleich von masseninduzierten Kräften. Zu diesem Zweck ist die Feedforwardeinrichtung 80 mit den Aktormitteln 8 verbunden, um diese im Sinne der Dämpfung von auftretenden Schwingungen zu steuern.

Die masseninduzierten Kräfte werden in quasi kontinuierliche Kräfte und sprungartig auftretende Kräfte unterteilt. Quasi kontinuierliche Kräfte treten z.B. bei Schlittenbewegungen auf. Sprungartige Kräfte treten z.B. bei Übergabevorgängen von Werkstücken auf.

Die Feedforwardeinrichtung 80 ist auf die Bewältigung der quasi kontinuierlichen Kräfte und/oder der sprungartig auftretenden Kräfte ausgebildet.

Die Schlittenbewegung wirkt auf den Zustand des Interfaces 71 und allgemein der Maschine 72 ein. Diese Einwirkung kann mit einer Übertragungsfunktion (=Übertragungscharakteristik) beschrieben werden. Für jede Bewegung eines Maschinenteils der Maschine gibt es eine zugeordnete Übertragungsfunktion. Zu diesem Zweck der Kompensationssignalbildung weist die Feedforwardeinrichtung 80 eine Feedforwardsteuerung 82 mit einem Speicher für Übertragungsfunktionen auf.

Wie in Fig. 1 ist der Stage Controller 60 mit dem Antrieb des Schlittens 76 über Leitungen verbunden. Der Stage Controller 60 gibt Steuerungssignale an den Schlittenantrieb ab und meldet den Bewegungszustand des Schlittens 76 an die Feedforwardeinrichtung 82. Hierbei werden sowohl die Positions- als auch die Beschleunigungsdaten des Schlittens 76 weitergegeben.

Die vom Stage Controller 60 an die Feedforwardeinrichtung 82 gesendeten Daten zum Bewegungszustand des Schlittens 76 werden von der Feedforwardeinrichtung 82 mit der jeweils zutreffenden Übertragungsfunktion gefaltet. Das Ergebnis dieser Faltung wird von der Feedforwardeinrichtung 82 als Ansteuersignal an die Aktoren 8 gesendet. Diese werden hierdurch derart beeinflusst, dass die Auswirkungen der Bewegungen des Schlittens 76 auf den Schwingungszustand des Gesamtsystems minimiert werden.

Somit werden die Übertragungsfunktionen der Maschinenteile vorab in der Feedforwardeinrichtung 82 gespeichert, um zu passenden Gelegenheiten zur Verfügung zu stehen. Auf diese Weise werden im Ergebnis die durch die Bewegungen der Maschinenteile induzierten Kräfte vorweggenommen. Hierdurch wird die Gesamtanordnung schneller wieder in einen schwingungsarmen Zustand versetzt, als dies ohne ein derartiges Feedforwardsystem der Fall wäre.

Vorzugsweise wird das Feedforwardsystem als adaptives System ausgeführt, das während einer Einstellphase einmalig eine Übertragungsfunktion bzw. -charakteristik lernt", die die Auswirkungen der inertialen Kräfte auf die Bewegung der Masse reduziert. Das System kann aber auch manuell eingestellt werden, sofern die betreffende Übertragungsfunktion hinreichend einfach ist.

Je nach der Größe der Masse $M_B$ des beträgt das Verhältnis dieser Masse $M_B$ zu der bewegten Masse $m_2$ 4:1, 2:1, 1:1, 1:2, 1:4 oder noch weniger. Die Wahl des Masseverhältnisses hängt von der Art der Maschine ab, die schwingungsisoliert gelagert werden soll, ferner auch davon ab, wie gut das Feedforwardsystem die Schwingungen aktiv dämpfen kann. Wegen Störschwingungen vom Untergrund 9 her wünscht man sich die Masse $M_g$ des Gesamtsystems möglichst groß; zur Verkleinerung der Schwingungsisolatoren möchte man die Masse $M_g$ klein halten. Die Erfindung bietet einen guten Kompromiss zwischen diesen beiden sich widersprechenden Forderungen.

Soweit es gelingt, die auftretenden Schwingungen mit der Feedforwardeinrichtung 80 ausreichend gut zu dämpfen, kann man die Masse $M_B$ entsprechend klein machen und die angegebenen Masseverhältnisse erzielen.

In Fig. 2 ist noch ein zweites Ausführungsbeispiel enthalten, nämlich mit einer Feedforwardeinrichtung 83 für den Ausgleich sprungartig auftretender Kräfte. Zu diesem Zweck weist die Steuerung 83 einen Speicher auf, der ein Modell der auftretenden Kräfte enthält. In dem Speicher der Feedforwardsteuerung 83 werden somit vorab Ausgleichsignale oder Gegenkraftsignale zu den sprungartig auftretenden Kräften gespeichert.

Bei diesen Anwendungsfällen, in denen die Bewegung einen Sprungcharakter hat, z.B. beim Andocken eines Teils oder der Übergabe eines Werkstücks, wird zum Ausgleich der Auswirkungen derartiger Bewegungen auf das Gesamtsystem die Feedforwardsteuerung 83 tätig. Die Information zur Initiierung der Kompensationssignalbildung erhält die Feedforwardsteuerung 83 von dem Verursacher 61 der störenden Schwingung, z.B. einem Roboter, der das Werkstück 77 auf dem Schlitten 76 ablegt bzw. von ihm entfernt.

Wenn die sprungartig auftretenden Kräfte auftreten, triggern sie die Feedforwardsteuerung 83 und diese ruft die gespeicherten Ausgleichs- oder Gegenkraftsignale aus dem Speicher ab, um sie an die Aktormittel 8 weiterzugeben. So wird den Auswirkungen sprungartiger Kräfte bereits im Moment ihrer Entstehung entgegengewirkt.

Somit kann auch die Feedforwardsteuerung 83 dazu beitragen, die Basismasse $M_B$ gegenüber dem Stand der Technik verringern zu können.

**Patentansprüche**

1. Schwingungsisolationssystem umfassend eine Basismasse ($M_B$);
Schwingungsisolatoren (74) zur Stützung der Basismasse ($M_B$) gegenüber einer Unterlage (9) unter Einbezug von Federsystemen niedriger Steifigkeit;
eine Maschine (72), die eine Gesamtmasse ($M_M$) bei einer stationären Masse ($m_1$) von stationären Maschinenteilen (75) und bei einer bewegten Masse ($m_2$) von bewegbaren Maschinenteilen (73) aufweist und auf der Basismasse ($M_B$) gelagert ist, wobei die bewegbaren Maschinenteile (73) eine Quelle inertialer Kräfte innerhalb der Maschine (72) darstellen,

ein Regelsystem (8, 79, 81), das Sensormittel (79) zur Erfassung von Schwingungen der Basismasse ($M_B$), Aktormittel (8) zur Beeinflussung der Schwingungen der Basismasse ($M_B$) und einen Regler (81) umfasst, und
ein Feedforwardsystem (80), das die Aktormittel (8) steuert und mindestens eine Steuereinheit (82,83) mit einem Speicher beinhaltet,

**dadurch gekennzeichnet, dass**
zur Verringerung der Gesamtmasse des Systems und zu Zwecken der Verkleinerung der Schwingungsisolatoren (74)
die Basismasse ($M_B$) gegenüber der bewegten Masse ($m_2$) der Maschine (72) auf ein Masseverhältnis 7:1, oder weniger, reduziert ist, und
dass das Feedforwardsystem (80) vorgesehen ist, um in der Maschine (72) die Auswirkungen von zu erwartenden inertialen Kräften gleichzeitig mit deren Erzeugung zu kompensieren, wobei der Speicher Übertragungsfunktionen der bewegbaren Maschinenteile und dabei ein Modell der auftretenden Kräfte, sowie Ausgleichssignale oder Gegenkraftsignale zu den sprunghaft auftretenden Kräften enthält.

2. Schwingungsisolationssystem gemäß Anspruch 1, **dadurch gekennzeichnet, dass** das Masseverhältnis Basismasse ($M_B$) zu bewegter Masse ($m_2$) der Maschine (72) bis zu 4:1 beträgt.

3. Schwingungsisolationssystem gemäß Anspruch 1, **dadurch gekennzeichnet, dass** das Masseverhältnis Basismasse ($M_B$) zu bewegter Masse ($m_2$) der Maschine (72) bis zu 2:1 beträgt.

4. Schwingungsisolationssystem gemäß Anspruch 1, **dadurch gekennzeichnet, dass** das Masseverhältnis Basismasse ($M_B$) zu bewegter Masse ($m_2$) der Maschine (72) bis zu 1:1 beträgt.

5. Schwingungsisolationssystem gemäß Anspruch 1, **dadurch gekennzeichnet, dass** das Masseverhältnis Basismasse ($M_B$) zu bewegter Masse ($m_2$) der Maschine (72) bis zu 1:2 beträgt.

6. Schwingungsisolationssystem gemäß Anspruch 1, **dadurch gekennzeichnet, dass** das Masseverhältnis Basismasse ($M_B$) zu bewegter Masse ($m_2$) der Maschine (72) bis zu 1:4 beträgt.

7. Verfahren zur Verkleinerung von Schwingungsisolatoren (74), die ein Federsystem niedriger Steifigkeit beinhalten, in einem Schwingungsisolationssystem für eine Maschine (72), die eine Gesamtmasse ($M_M$) bei einer stationären Masse ($m_1$) von stationären Maschinenteilen (75) und bei einer bewegten Masse ($m_2$) von bewegbaren Maschinenteilen (73) aufweist und auf einer Basismasse ($M_B$) gelagert ist, wobei die bewegbaren Maschinenteile (73) eine Quelle inertialer Kräfte innerhalb der Mas 16 (72) darstellen,

mit folgenden Schritten:

Entwerfen eines Arbeitstisches (70) und einer Struktureinheit (71) zum Halten der Maschine (72) auf dem Arbeitstisch, die zusammen die Basismasse ($M_B$) darstellen, so dass ein Masseverhältnis der Basismasse ($M_B$) gegenüber der bewegten Masse ($m_2$) von 7:1 oder weniger eingehalten wird;

Einrichten eines Feedforwardsystems (80), das in der Maschine (72) zu erwartende inertiale Kräfte gleichzeitig mit deren Auftreten kompensiert, wobei das Feedforwardsystem (80) Aktormittel (8) steuert und mindestens eine Steuereinheit (82, 83) beinhaltet, die einen Speicher für Übertragungsfunktionen der bewegbaren Maschinenteile aufweist, wobei der Speicher ferner als ein Modell der auftretenden Kräfte Ausgleichssignale oder Gegenkraftsignale zu den sprunghaft auftretenden Kräften enthält.

## Claims

1. A vibration isolation system, comprising:

   a base mass ($M_B$);
   vibration isolators (74) for supporting the base mass ($M_B$) on a floor (9) using spring systems of low stiffness;
   a machine (72) having a total mass ($M_M$) with a stationary mass ($m_1$) of stationary machine parts (75) and with a moving mass ($m_2$) of moving machine parts (73) and being supported on the base mass ($M_B$), said movable machine parts (73) representing a source of inertial forces in the machine (72);
   a control system (8, 79, 81) comprising sensor means (79) for detecting vibrations of the base mass ($M_B$), actuator means (8) for influencing the vibrations of the base mass ($M_B$), and a controller (81); and
   a feedforward system (80) controlling the actuator means (8) and comprising at least one control unit (82, 83) including a memory;

   **characterized in that**

   for reducing the total mass of the system and for the purposes of reducing the size of the vibration isolators (74), the base mass ($M_B$) is reduced to a mass ratio of 7:1 or less with respect to the moving mass ($m_2$) of the machine (72); and that
   the feedforward system (80) is adapted for compensating the impact of expected inertial forces in the machine (72) at the time of their generation,

wherein the memory contains transfer functions of the moving machine parts and thereby a model of the occurring forces, and compensation signals or counterforce signals for the abruptly occurring forces.

2. The vibration isolation system according to claim 1, **characterized in that** the mass ratio of base mass ($M_B$) to moving mass ($m_2$) of the machine (72) is at most 4:1.

3. The vibration isolation system according to claim 1, **characterized in that** the mass ratio of base mass ($M_B$) to moving mass ($m_2$) of the machine (72) is at most 2:1.

4. The vibration isolation system according to claim 1, **characterized in that** the mass ratio of base mass ($M_B$) to moving mass ($m_2$) of the machine (72) is at most 1:1.

5. The vibration isolation system according to claim 1, **characterized in that** the mass ratio of base mass ($M_B$) to moving mass ($m_2$) of the machine (72) is at most 1:2.

6. The vibration isolation system according to claim 1, **characterized in that** the mass ratio of base mass ($M_B$) to moving mass ($m_2$) of the machine (72) is at most 1:4.

7. A method for reducing the size of vibration isolators (74) that comprise a spring system of low stiffness in a vibration isolation system for a machine (72) that has a total mass ($M_M$) with a stationary mass ($m_1$) of stationary machine parts (75) and with a moving mass ($m_2$) of moving machine parts (73) and which is supported on a base mass ($M_B$), wherein said movable machine parts (73) are a source of inertial forces in the machine (72); comprising the steps of:

   designing a worktable (70) and a structural unit (71) for supporting the machine (72) on the worktable, which together define the base mass ($M_B$), in such a manner that a mass ratio of base mass ($M_B$) to moving mass ($m_2$) of 7:1 or less is respected;
   establishing a feedforward system (80) which compensates for inertial forces that are expected in the machine (72) at the time of their generation, wherein the feedforward system (80) controls actuator means (8) and comprises at least one control unit (82, 83) including a memory for transfer functions of the moving machine parts, wherein the memory further includes, as a model of occurring forces, compensation signals or counterforce signals for the abruptly occurring forces.

**Revendications**

1. Système d'isolation de vibrations comprenant une masse de base ($M_B$) ;
des isolateurs de vibrations (74) pour l'appui de la masse de base ($M_B$) par rapport à un substrat (9) au moyen de systèmes de ressorts de faible rigidité ;
une machine (72), qui présente une masse totale ($M_M$) avec une masse fixe ($m_1$) de pièces (75) de machine fixes et avec une masse mobile ($m_2$) de pièces (73) de machine mobiles et qui est montée sur la masse de base ($M_B$),
les pièces (73) de machine mobiles constituant une source de forces d'inertie à l'intérieur de la machine (72),
un système de régulation (8, 79, 81) comprenant des moyens capteurs (79) pour la détection de vibrations de la masse de base ($M_B$), des moyens actionneurs (8) pour agir sur les vibrations de la masse de base ($M_B$) et un régulateur (81), et
un système à action directe (80) qui commande les moyens actionneurs (8) et comprend au moins une unité de commande (82, 83) avec une mémoire, **caractérisé en ce que**
pour diminuer la masse totale du système et réduire les isolateurs de vibrations (74),
la masse de base ($M_B$) est ramenée à un rapport massique de 7:1 ou moins par rapport à la masse mobile ($m_2$) de la machine (72), et
**en ce que** le système à action directe (80) est prévu pour compenser les effets attendus des forces d'inertie dans la machine (72) simultanément à leur génération, la mémoire comprenant des fonctions de transmission des pièces de machine mobiles et un modèle des forces générées, ainsi que des signaux de compensation ou des signaux de forces antagonistes des forces générées par à-coups.

2. Système d'isolation de vibrations selon la revendication 1, **caractérisé en ce que** le rapport massique entre la masse de base ($M_B$) et la masse mobile ($m_2$) de la machine (72) est inférieur ou égal à 4:1.

3. Système d'isolation de vibrations selon la revendication 1, **caractérisé en ce que** le rapport massique entre la masse de base ($M_B$) et la masse mobile ($m_2$) de la machine (72) est inférieur ou égal à 2:1.

4. Système d'isolation de vibrations selon la revendication 1, **caractérisé en ce que** le rapport massique entre la masse de base ($M_B$) et la masse mobile ($m_2$) de la machine (72) est inférieur ou égal à 1:1.

5. Système d'isolation de vibrations selon la revendication 1, **caractérisé en ce que** le rapport massique entre la masse de base ($M_B$) et la masse mobile ($m_2$) de la machine (72) est inférieur ou égal à 1:2.

6. Système d'isolation de vibrations selon la revendication 1, **caractérisé en ce que** le rapport massique entre la masse de base ($M_B$) et la masse mobile ($m_2$) de la machine (72) est inférieur ou égal à 1:4.

7. Procédé de réduction d'isolateurs de vibrations (74) comprenant un système de ressorts de faible rigidité, dans un système d'isolation de vibrations pour une machine (72), qui présente une masse totale ($M_M$) avec une masse fixe ($m_1$) de pièces (75) de machine fixes et avec une masse mobile ($m_2$) de pièces (73) de machine mobiles et qui est montée sur une masse de base ($M_B$), les pièces (73) de machine mobiles constituant une source de forces d'inertie à l'intérieur de la machine (72), comprenant les étapes suivantes :

   conception d'une table de travail (70) et d'une unité structurelle (71) pour le maintien de la machine (72) sur la table de travail, qui constituent ensemble la masse de base ($M_B$), de manière à respecter un rapport massique de 7:1 ou moins entre la masse de base ($M_B$) et la masse mobile ($m_2$) ;
   configuration d'un système à action directe (80) qui compense les effets attendus des forces d'inertie dans la machine (72) simultanément à leur génération, le système à action directe (80) commandant des moyens actionneurs (8) et comprenant au moins une unité de commande (82, 83) pourvue d'une mémoire pour des fonctions de transmission des pièces de machine mobiles, ladite mémoire comprenant en outre, comme modèle des forces générées, des signaux de compensation ou des signaux de forces antagonistes des forces générées par à-coups.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050041233 A1
- US 4821205 A

- EP 502578 A